# Europäisches Patentamt
## European Patent Office
## Office européen des brevets

(19)

(11) Veröffentlichungsnummer: **0 002 751**
**B1**

(12) **EUROPÄISCHE PATENTSCHRIFT**

(45) Veröffentlichungstag der Patentschrift: **09.06.82**

(21) Anmeldenummer: **78101717.3**

(22) Anmeldetag: **16.12.78**

(51) Int. Cl.³: **H 01 L 23/56,**
**H 03 K 19/00,**
**H 03 K 19/08, H 01 L 29/86**

(54) **Schaltkreis zur Einstellung des Widerstandswertes eines Abschlusswiderstandes von Leitverbindungen in Halbleiterstrukturen.**

(30) Priorität: **30.12.77 US 865808**

(43) Veröffentlichungstag der Anmeldung:
**11.07.79 Patentblatt 79/14**

(45) Bekanntmachung des Hinweises auf die Patenterteilung:
**09.06.82 Patentblatt 82/23**

(84) Benannte Vertragsstaaten:
**DE FR GB**

(56) Entgegenhaltungen:
**CH - A - 495 669**
**DE - A - 2 122 292**
**DE - B - 1 293 846**
**FR - A - 1 346 727**

**IBM TECHNICAL DISCLOSURE BULLETIN, Band
17, Dezember 1974, New York, USA
A. E. BARISH et. al., "Active terminator", Seite
1960**

(73) Patentinhaber: **International Business Machines
Corporation
Armonk, N.Y. 10504 (US)**

(72) Erfinder: **Anantha, Narasipur Gundappa
1 Valdemar Road
Hopewell Junction N.Y. 12533 (US)**
Erfinder: **Henle, Robert Athanasius
Sunset Trail
Clinton Corners N.Y. 12514 (US)**
Erfinder: **Walsh, James Leo
23 South Drive
Hyde Park N.Y. 12538 (US)**

(74) Vertreter: **Gaugel, Heinz, Dipl.-Ing.
Schönaicher Strasse 220
D-7030 Böblingen (DE)**

Schaltkreis zur Einstellung des Widerstandswertes eines Abschlusswiderstandes von Leitverbindungen in Halbleiterstrukturen

Die Erfindung betrifft einen Schaltkreis zur Einstellung des Widerstandswertes eines Abschlußwiderstandes von Leitverbindungen in Halbleiterstrukturen, dessen Widerstandswert durch eine Steuer-spannung einstellbar ist.

Bei Halbleiterstrukturen besteht die Aufgabe, die Impendanz des Übertragungswiderstandes einer Leitverbindung, die z.B. von einer Schaltkarte über ein Modul zum Schaltkreis eines Chips verläuft, so an den Schaltkreiswiderstand anzupassen, daß eine Dämpfung der übertragenen Signale durch Leitungsverluste nach Möglichkeit vermieden wird. Durch eine Fehlanpassung von Leitverbindungen sollen ferner Reflexionen am Ende der Leitverbindung vermieden werden, damit die Signale nach Möglichkeit verzerrungsfrei übertragen werden können. In Halbleiterstrukturen bekannter Art wurde die Aufgabe der Anpassung von Schaltkreisen an Leitverbindungen dadurch gelöst, daß einem Chip mehrere Diffusionswiderstände zugeordnet wurden, die verschiedene Widerstände aufwiesen. Ein ausgewählter Diffusionswiderstand wurde als Abschlußwiderstand verwendet, wenn ein Schaltkreis eines Chips einer vorgegebenen Halbleiterstruktur zugeordnet wurde.

In Halbleiterstrukturen ist es ferner bekannt (US—Patente 3 510 735, 3 801 886, "Physics and Technology of Semiconductor Devices", A. S. Grove, John Wiley & Son, Inc. New York, copyright 1967, Seiten 244—251), in Halbleiterstrukturen sogenannte Pinch-Widerstände zu verwenden. Ein Widerstand dieser Art besteht aus einem Kanal, der durch ein Halbleitermaterial bestimmter Dotierung gebildet wird. Beiderseits des Kanals befinden sich Halbleitermaterialien entgegengesetzter Dotierung, die durch Steuerelektroden mit einer Steuerspannung verbindbar sind. Durch eine vorgegebene Bemessung dieser Steuerspannung kann der Widerstandskanal bezüglich der elektrischen Leitfähigkeit verengt oder erweitert werden.

Es ist die Aufgabe der vorliegenden Erfindung, den Abschlußwiderstand einer Leitverbindung in Halbleiterstrukturen so auszubilden, daß er an eine gewählte Leitverbindung mit größtmöglicher Genauigkeit stufenlos eingestellt werden kann.

Die genannte Aufgabe wird gemäß der vorliegenden Erfindung dadurch gelöst, daß

a) der Abschlußwiderstand durch einen sogenannten Pinch-Widerstand gebildet wird,

b) durch eine Leitverbindung übertragene Signale einem Anschluß des Pinch-Widerstandes und einem ersten Steuereingang eines Differenzverstärkers zugeführt werden,

c) der zweite Steuereingang des Differenzverstärkers mit einer gewählten Bezugsspannung verbunden ist,

d) der Ausgang des Differenzverstärkers über Kopplungswiderstände mit dessen Steuereingängen verbunden ist,

e) der Ausgang des Differenzverstärkers über einen Zwischenverstärker mit einer Steuerelektrode des Pinch-Widerstandes verbunden ist.

Besondere Ausführungsarten der Erfindung sind in den Unteransprüchen gekennzeichnet.

Eine Einrichtung der genannten Art hat den Vorteile, daß die Packungsdichte einer Halbleiterstruktur bei größerer Genauigkeit der Betriebsfunktionen erhöht werden kann.

Ein Weg zur Ausführung der Erfindung ergibt sich aus der nachfolgenden Beschreibung von Abbildungen.

Es zeigen:

Fig. 1 die Anordnung einer mit einem Abschlußwiderstand verbundenen Leitverbindung, die eingangsseitig durch einen Signalgenerator gespeist wird,

Fig. 2 die Seitenansicht des Aufbaus einer Halbleiterstruktur, die durch ein Chip gebildet wird, dessen Modul durch Kontaktstifte mit einer Schaltkarte verbunden ist,

Fig. 3 eine Ersatzschaltung der Fig. 1 dargestellten leitverbindung, deren Leitungskapazitäten vorgegebene Abstände aufweisen,

Fig. 4 die Charakteristik der Leitungsimpedanz der in Fig. 3 gezeigten Leitverbindung, abhängig vom Abstand von zwei nebeneinander angeordneten Leitungskapazitäten,

Fig. 5 die Hintereinanderanordnung eines Leitungsabschnitts ohne Leitungskapazitäten und eines Leitungsabschnitts mit Leitungskapazitäten,

Fig. 6 einen Schaltkreis zur Einstellung des Widerstandswertes eines als Pinch-Widerstand ausgebildeten Abschlußwiderstandes durch eine Bezugsspannung,

Fig. 7 die vereinfachte Ausführungsform eines Schaltkreises zur Einstellung des Widerstandswertes eines als Pinch-Widerstand ausgebildeten Abschlußwiderstandes durch eine Bezugsspannung,

Fig. 8 die Halbleiterstruktur eines Pinch-Widerstandes, der als Abschlußwiderstand einer Leitverbindung benutzt wird,

Fig. 9 die Strom/Spannungs-Charakteristika des in Fig. 8 dargestellten Pinc-Widerstandes der mit verschiedenen Steuerspannungen betrieben wird,

Fig. 10 die Topologie eines Teils der für den Zweck der vorliegenden Erfindung benutzten Halbleiterstrukturen,

Fig. 11 die Anordnung von Halbleitermodulen an einer Schaltkarte, zwischen denen Leitverbindungen für die Signalübertragung vorgesehen sind.

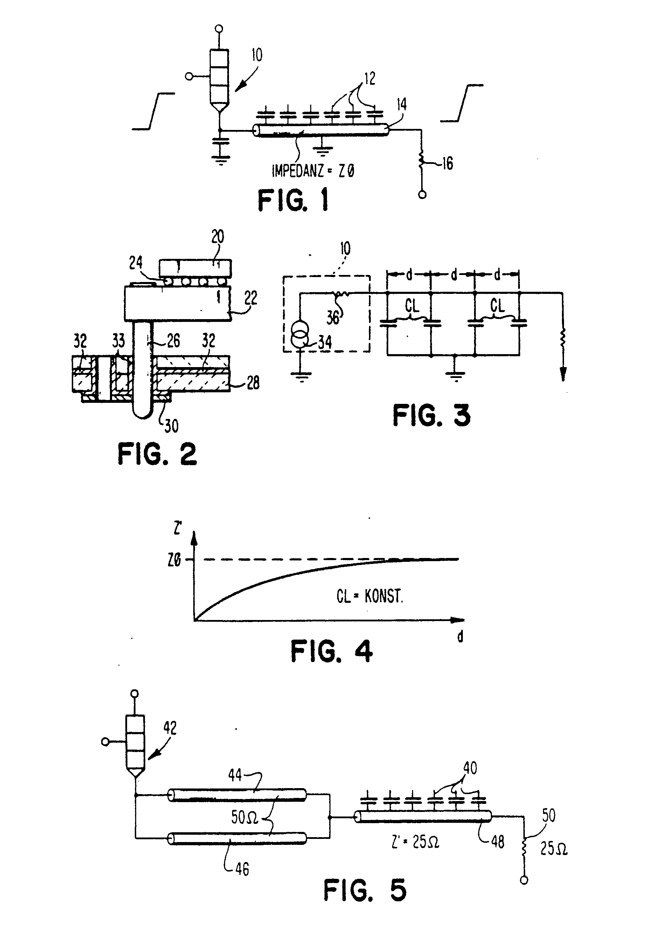

Die in Fig. 1 dargestellte Treiberschaltung 10 bildet den Eingang einer Leitverbindung 14, deren Ausgang mit dem Abschlußwiderstand 16 verbunden ist. Die Impedanz der Leitverbindung 14 wird gebildet durch eine Anzahl von Kapazitäten 12, die entlang der Verbindungsleitung 14 in verschiedenen Abständen angeordnet sind. Die verschiedenen Abstände der Kapazitäten 12 ergeben eine weiten Bereich verschiedener Impedanzwerte, der Verbindungsleitung 14, an welche der Widerstandswert des Abschlußwiderstandes 16 anzupassen ist. Um für die jeweils benötigte Leitungslänge der Verbindungleitung 14 eine genaue Anpassung zu erhalten, wäre eine große Anzahl von Abschlußwiderständen 16 erforderlich, die verschiedene Werte aufweisen.

Fig. 2 zeigt die räumliche Anordnung der Elemente einer Halbleiterschaltung die eine Verbindungsleitung kapazitiver Impedanz ergeben. Das Chip 20 eines integrierten Schaltkreises ist durch Lötpunkte 24 mit der Oberfläche des Moduls 22 verbunden. Durch Leitverbindungen, die an der Oberfläche des Moduls 22 angeordnet sind, sind die verschiedenen Lötpunkte 24 verbinden. Die Leitverbindungen können auch innerhalb des Modulkörpers angeordnet sein. Die Kontaktstifte 26 eines Moduls 22 verbinden den Schaltkreis des Chips 20 mit der Schaltkarte 28. Die Kontaktstifte 26 erstrecken sich durch eine Öffnung der Schaltkarte 28, wodurch eine elektrische Verbindung über die Metallschichten 30 zu einer Leitverbindung 32 innerhalb der Schaltkarte 28 hergestellt wird. Für Änderungen des Schaltungsaufbaus sind zwei zusätzliche, nicht benützte Öffnungen der Schaltkarte 28 vorgesehen. Die Oberfläche einer jeden Öffnung ist mit einer Metallschicht 33 bedeckt. Die kapazitven Belastungen einer Leitverbindung ergeben sich durch die einzelnen Bauelemente einer Anordnung, wie z.B. Löcher, Kontaktfedern, Modulschichten usw. Die in Fig. 1 dargestellten, entlang der Leitverbindung 14 angeordneten Kapazitäten 12 ergeben sich aus der räumlichen Anordnung eines jeden einzelnen Moduls, das durch die Treiberschaltung 10 gespeist wird.

Gemäß der Darstellung nach Fig. 3 ergibt sich das Ersatzschaltbild einer gemäß Fig. 1 dargestellten Verbindungsleitung, wenn diese durch die Leitungskapazitäten CL belegt ist. Die Treiberschaltung 10 enthält die Spannungsquelle 34, die den inneren Widerstand 36 aufweist. Die kapazitiv belastete Verbindungsleitung hat den Impedanzwert $Z'$ im Gegensatz zum Impedanzwert $Z\emptyset$, der nicht kapazitiv belasteten Verbindungsleitung. Es ergibt sich die folgende rechnerische Beziehung zwischen diesen beiden Werten:

$$Z' = \frac{Z\emptyset}{1 + \dfrac{\mu CL}{Cd}}$$

$\mu$ = Kapazitätsbeiwert von CL

C = Leitungskapazität ohne Belastungskapazitäten

d = Abstand zwischen den Belastungskapazitäten CL

$Z\emptyset$ = Impedanz der Leitverbindung ohne Belastungskapazitäten

$Z'$ = Impedanz der Verbingungsleitung mit Belasungskapazitäten

Fig. 4 zeigt die Abhängigkeit der Impendanz der Leitverbindung von der Größe des Abstandes d zwischen zwei Belastungskapazitäten CL. Für diese Darstellung sei angenommen, daß der Abstand d zwischen zwei Belastungskapazitäten CL, deren Wert konstant ist, verändert wird.

Fig. 5 zeigt ein Ausführungsbeispiel, bei welchem eine Leitverbindung unterteilt ist in einen ersten Abschnitt, der nich kapazitiv belastet ist, und in einen zweiten Abschnitt, der kapazitiv belastet ist. Die gesamte Leitverbindung wird gespeist durch eine Treiberschaltung, die durch den Transistor 42 gebildet wird. Der erste Abschnitt der Leitverbindung besteht aus den beiden parallel geschalteten Widerständen 44 und 46, die jeweils einen Widerstandswert von 50 Ohm aufweisen. Der Impedanzwert $Z_1$ dieses ersten Abschnitts hat somit den Widerstandswert 25 Ohm. Daran angepaßt ist der Widerstandswert $Z' = 25$ Ohm der durch die Kapazitäten 40 belasteten Leitverbindung 48 des zweiten Abschnitts. Der Ausgang der Leitverbindung ist verbunden mit dem Abschlußwiderstand 50 von 25 Ohm.

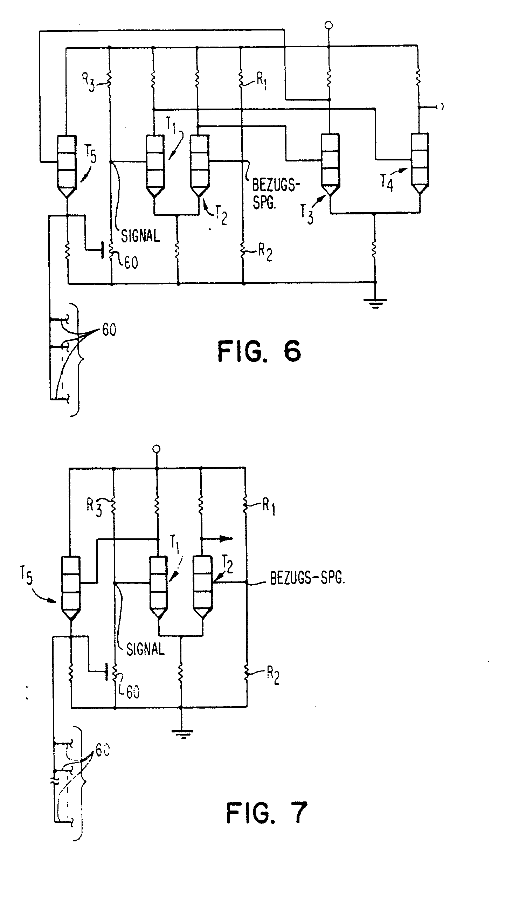

Durch den in Fig. 6 dargestellten Schaltkreis wird eine Betriebsspannung für den Pinch-Widerstand erzeugt, dessen Widerstandswert für die genaue Bemessung des Abschlußwiderstandes einer Leitverbindung durch die Betriebsspannung einstellbar ist. Die Betriebsspannung wird erzeugt durch einen Differenzverstärker, der durch die beiden Transistoren $T_1$ und $T_2$ gebildet wird. Dem einen Steuereingang des Differenzverstärkers wird das Übertragungssignal und dem anderen Steuereingage des Differenzverstärkers wird eine Bezugsspannung zugeführt. Beide Eingangsspannungen werden verglichen, wodurch aus der Differenz der beiden Eingangssignale am Ausgang des Differenzverstärkers ein Signal ableitbar ist. Dieses wird zu de Eingängen eines zweiten Differenzverstärkers übertragen, der durch die beiden Transistoren $T_3$ und $T_4$ gebildet wird. Das Ausgangssignal dieses zweiten Differenzverstärkers wird durch einen Zwischenverstärker, der durch den Transistor $T_5$ in Emitter-Folge-Schaltung gebildet wird, zu der Steuerelektrode des Pinch-Widerstandes 60 übertragen. Die dadurch bewirkte Widerstandsänderung hat eine Verkleinerung der am Ausgang des ersten Differenzverstärkers wirksamen Differenzspannung zur Folge. Das Verhältnis der beiden Widerstände $R_1$ und $R_2$ ist änderbar. Der Wert der Bezugsspannung wird bestimmt durch das Verhältnis dieser beiden Widerstände. Der Wert des änderbaren Pinch-Widerstandes ergibt sich aus der Beziehung:

$$\text{änderbarer Widerstand} = K \times R_3 \left( \frac{R2}{R1} \right)$$

wobei K einen veränderlichen Wert darstellt, der sich aus dem Verstärkungsfaktor des Schaltkreises und der Charakteristik des änderbaren Widerstandes ergibt. Das Ausgangssignal des durch den Transistor $T_5$ gebildeten Zwischenverstärkers speist eine Mehrzahl von änderbaren Abschlußwiderständen 60, die auf einem Chip angeordnet sind. Zu diesem Zweck ist der Ausgang des Transistors $T_5$ mit den Steuerelektroden dieser Pinch-Widerstände verbunden. Die Fig. 6 zeigt die Schaltverbindungen eines Pinch-Widerstandes. Entsprechend dieser Anordnung sind jeweils die zweite Elektrode der anderen, nicht dargestellten Pinch-Widerstände mit Erde und jeweils deren dritte Elektrode mit einem Schaltkreis verbunden, wie diesser in Fig. 6 gezeigt ist.

Die in Fig. 7 dargestellte, vereinfachte Ausführungsform eines Schaltkreises für die Erzeugung einer Steuerspannung zur Änderung des Widerstandswertes eines Pinch-Widerstandes enthält nur einen Differenzverstärker, der durch die beiden Transistoren $T_1$ und $T_2$ gebildet wird. Der entsprechend der Darstellung nach Fig. 6 benutzte zweite Differenzverstärker mit den Transistoren $T_3$ und $T_4$ dient lediglich einer Erhöhung der Genauigkeit.

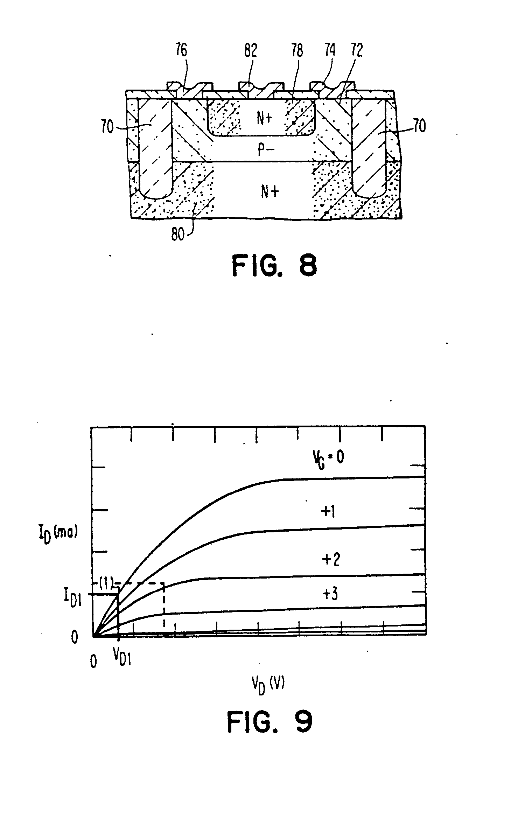

Die in Fig. 8 gezeigte Halbleiterstruktur eines änderbaren Pinch-Widerstandes enthält einen Bereich eines monokristallinen Siliconmaterials, der durch ein dielektrisches Material 70 isoliert wird. Der Widerstandskanal 72 bildet einen P-Bereich mit den Anschlußkontakten 74 und 76 an entgegengesetzten Enden des Widerstandes. Ein erster N+-Bereich 78 liegt in der Mitte des Widerstandskanals 72. Dieser Bereich 78 bildet mit dem N+-Bereich 80 einen schmalen Kanal im Widerstandskanal 72. Der Anschlußkontakt 82, der mit dem N+-Bereich 78 verbunden ist, bildet die Steuerelektrode des änderbaren Pinch-Widerstandes. Die N+-Bereiche 78 und 80 erhalten bezüglich des Bereiches des Widerstandskanals 72 stets eine positive Vorspannung. Dies hat zur Folge, daß im Bereich des Widerstandskanals 72 Leerstellen vorhanden sind. Wenn die positiven Vorspannungswert erhöht werden, weiten sich die Leerstellenbereich aus und der Widerstandswert zwischen den Anschlußkontakten 74 und 76 nimmt zu. Eine Verkleinerung dieses Widerstandswerte findet statt, wenn die positiven Vorspannungswerte verkleinert werden. Der Anschlußkontakt 82, der als Steuerelektrode benutzt wird, wird gemäß der Darstellung nach den Fign. 6 und 7 mit dem Ausgang des Transistors $T_5$ verbunden.

Die Strom/Spannungs-Kennlinien des in Fig. 8 dargestellten Pinch-Widerstandes ergeben sich aus der Darstellung nach Fig. 9. Die verschiedenen Strom/Spannungs-Kennlinien sind dargestellt in Abhängigkeit von den verschiedenen Parametern einer Steuerspannung $V_G$, die an die Steuerelektrode 82 des Pinch-Widerstandes 60 angelegt werden. Dabei ergeben sich abhängig von den an die Anschlußkontakte 76 und 74 des Widerstandskanals 72 angelegten Signalspannungen $V_D$, die durch den Widerstandskanal 72 fließenden Ströme $I_D$. Das jeweilige Verhältnis von $V_D$ zu $I_D$ eines jeden Punktes einer der Kennlinien liefert somit den jeweiligen Ist-Wert des Pinch-Widerstandes. Z.B. ergibt sich dieser am Punkt (1) der $V_6 = 0$ Kennlinie durch das Verhälinis $V_{D1}$ zu $I_{D1}$. Der auswertbare Betriebsbereich des Pinch-Widerstandes liegt innerhalb des durch unterbrochene Strichlinien begrenzten Bereiches des Kennlinienfeldes.

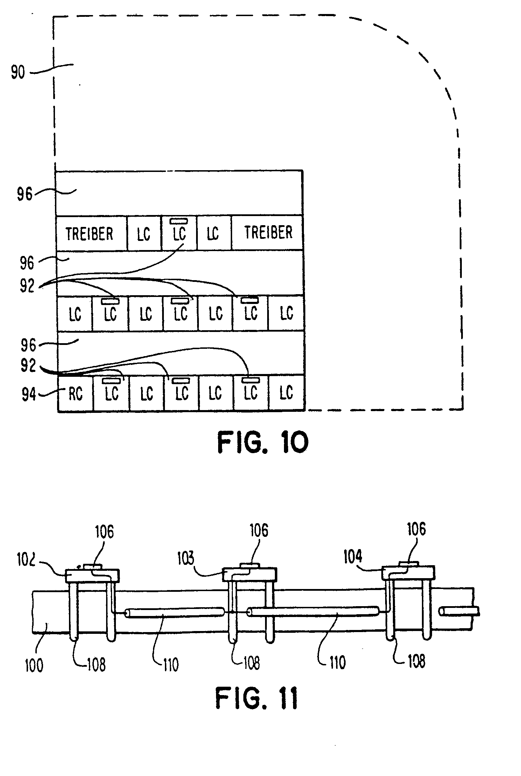

Die Fig. 10 zeigt die Topologie eines in der integrierten Schaltkreistechnik ausgeführten Silicon-Chips 90. Die logischen Schaltkreise LC können in bipolarer Technik ausgeführt sein, z.B. als emittergekoppelte Logik, Transistor-Transistor gekoppelte Logik und Dioden-Transistor gekoppelte Logik. Die Bereiche 92 mit logischen Schaltkreisen, die ähnlich den Bereichen LC ausgeführt sind, enthalten jeweils einen steuerbaren Abschlußwiderstand. Die Treiber-Schaltkreise sind besonderen Bereichen zugeordnet. Aus Schaltkreisen des Bereichs 94 wird die Bezungsspannung für die Steuerung der änderbaren Pinch-Widerstände abgeleitet. Auf einem Chip können entweder einer oder mehrere dieser Bereiche 94 für die Steuerung von mehreren Pinch-Widerständen vorgesehen sein. Die Bereiche 96 sind für Leitungsführungen vorgesehen.

Die Fig. 11 erläutert den Aufbau der Moduls 102, 103 und 104, welche die Chips 106 tragen, an der Schaltkarte 100. Die Moduln sind durch Kontaktstifte 108 mechanisch und elektrisch mit der Schaltkarte 100 verbunden. Übertragungsleitungen 110 verbinden die Chips 106.

**Pantenansprüche**

1. Schaltkreis zur Einstellung des Widerstandswertes eines Abschlußwiderstandes (60) von Leitverbindungen in Halbleiterstrokturen, dessen Widerstandswert durch eine Steuerspannung ($V_G$) einstellbar ist, dadurch gekennzeichnet, daß

a) der Abschlußwiderstand durch einen sog. Pinch-Widerstand (60) gebildet wird,

b) durch eine Leitverbindung übertragene Signale einem Anschluß des Pinch-Widerstandes (60) und einem ersten Steuereingang eines Differenzverstärkers ($T_1$, $T_2$) zugeführt werden,

c) der zweite Steuereingang des Differenzverstärkers ($T_1$, $T_2$) mit einer gewählten Bezugsspannung verbunden ist,

d) der Ausgang des Differenzverstärkers ($T_1$,

$T_2$) über Kopplungswiderstände mit dessen Steuereingängen verbunden ist,

e) der Ausgang des Differenzverstärkers ($T_1$, $T_2$) über einen Zwischenverstärker ($T_5$) mit einer Steuerelektrode des Pinch-Widerstandes (60) verbunden ist.

2. Schaltkreis nach Anspruch 1, dadurch gekennzeichnet, daß die beiden Ausgänge der zwei Transistoren ($T_1$, $T_2$) des Differenzverstärkers jeweils mit einer Eingangselektrode der zwei Transistoren ($T_3$, $T_4$) eines zweiten Differenzverstärkers verbunden sind, dessen Ausgang über den als Transistor ($T_5$) ausgebildeten Zwischenverstärker mit der Steuerelektrode des Pinch-Widerstandes verbunden ist.

3. Schaltkreis nach einem der Ansprüche 1 oder 2, dadurch gekennzeichnet, daß der Ausgang des Zwischenverstärkers ($T_5$) mit den Steuerelektroden einer Anzahl von Pinch-Widerständen (60) verbunden ist, von denen jeder den Abschlußwiderstand einer Leitverbindung bildet.

## Claims

1. Circuit for adjusting the resistance of a terminating resistor (60) of interconnections in semiconductor structures, the resistance of which is adjustable by a control voltage ($V_G$), characterized in that:

a) the terminating resistor is formed by a so-called pinch resistor (60),

b) signals transmitted by an interconnection are applied to a contact of the pinch resistor (60) and a first control input of a differential amplifier ($T_1$, $T_2$),

c) the second control input of the differential amplifier ($T_1$, $T_2$) is connected to a selected reference voltage,

d) the output of the differential amplifier ($T_1$, $T_2$) is connected to its control inputs via coupling resistors,

e) the output of the differential amplifier ($T_1$, $T_2$) is connected to a control electrode of the pinch resistor (60) via an interstage amplifier ($T_5$).

2. Circuit in accordance with claim 1, characterized in that the two outputs of the two transistors ($T_1$, $T_2$) of the differential amplifier are connected to one input electrode each of the two transistors ($T_3$, $T_4$) of a second differential amplifier, the output of which is connected to the control electrode of the pinch resistor via the transistor ($T_5$) designed as an interstage amplifier.

3. Circuit in accordance with any one of the claims 1 or 2, characterized in that the output of the interstage amplifier ($T_5$) is connected to the control electrodes of a plurality of pinch resistors (60), each of which forms the terminating resistor of an interconnection.

## Revendications

1. Circuit pour ajuster la valeur d'une résistance terminale (60) d'interconnexions dans des structures semi-conductrices, dont la valeur de résistance peut être ajustée au moyen d'une tension de commande ($V_G$), caractérisé en ce que:

a) la résistance terminale est formée par une résistance dite de pincement (60),

b) des signaux transmis par une interconnexion sont appliqués à un contact de la résistance de pincement (60) et à une première entrée de commande d'un amplificateur différentiel ($T_1$, $T_2$),

c) la seconde entrée de commande de l'amplificateur différentiel ($T_1$, $T_2$) est connectée à une tension de référence sélectionnée,

d) la sortie de l'amplificateur différentiel ($T_1$, $T_2$) est connectée à ses entrées de commande à travers des résistances de couplage,

e) la sortie de l'amplificateur différentiel ($T_1$, $T_2$) est connectée à une électrode de commande de la résistance de pincement (60) au moyen d'un amplificateur intermédiaire ($T_5$).

2. Circuit selon la revendication 1, caractérisé en ce que les deux sorties des deux transistors ($T_1$, $T_2$) de l'amplificateur différentiel sont connectées chacune à une électrode d'entrée des deux transistors ($T_3$, $T_4$) d'un second amplificateur différentiel dont la sortie est connectée à l'électrode de commande de la résistance de pincement à travers l'amplificateur intermédiaire constitué par un transistor ($T_5$).

3. Circuit selon la revendication 1 ou 2 caractérisé en ce que la sortie de l'amplificateur intermédiaire ($T_5$) est connectée avec les électrodes de commande d'une pluralité de résistances de pincement (60) dont chacune constitue la résistance terminale d'une interconnexion.

FIG. 1

FIG. 2

FIG. 3

FIG. 4

FIG. 5

FIG. 6

FIG. 7

FIG. 8

FIG. 9

FIG. 10

FIG. 11